# EUROPEAN PATENT APPLICATION

(11) **EP 1 180 691 A1**
(43) Date of publication of application: **20.02.2002**
(21) Application number: 00402249.7
(22) Date of filing: 08.08.2000
(51) Int. Cl.: G01R 31/28

(54) **Circuit and method for stress testing a transistor in an integrated circuit device**

(71) Applicant: MOTOROLA, INC., Schaumburg, IL 60196 (US)
(72) Inventor: Bertolini, Luca, 31300 Toulouse (FR); Ollitrault, Stéphane, 31600 Seysses (FR); Richetto, David, 31100 Toulouse (FR)
(74) Representative: Joly, Jean-Jacques

(57) **Abstract**

A circuit and method for stress testing a transistor (110) in an integrated circuit device comprising: an external connection pad (GST) coupled to the transistor; a first switch (Sn) coupled between the transistor and circuitry (130) within the integrated circuit device to which the transistor is connected during normal operation of the device; a second switch (Sg) coupled between the transistor and test circuitry for testing the transistor; and detecting means (C1, C2, DZ1, DZ2, DZ3) coupled to the pad for detecting when a signal applied thereto has at least a predetermined slew rate, and for disabling the first switch and enabling the first switch in response to this detection. The test is unaffected by the normally-operating circuitry; the test does not require an extra pad per gate for testing purposes; and the test may be performed during the stress state of the power transistor, allowing detection of small defects.

## Description

### Field of the Invention

This invention relates to stress testing of integrated circuit devices.

### Background of the Invention

In the field of this invention it is known to test an integrated circuit device, for example in the final stages of manufacture, in order to assess the likelihood of future device failure due to oxide defects. The test is typically performed by (i) stressing the gate oxide of a power transistor in the integrated circuit device (e.g., by raising the gate to source voltage of the power transistor up to a suitable level, usually close to the oxide breakdown voltage), and then (ii) measuring the current flowing after stressing of the oxide. The result of the test is considered good if only a very small current is flowing after stressing of the oxide.

However, this approach has the disadvantage(s) that:
- the power transistor is typically connected to circuitry (within the integrated circuit device) which normally doesn't withstand the amount of voltage needed for the gate stress or in this condition sinks a large amount of current, making the measurement unreliable or impossible;
- the test normally requires, only for this purpose, the presence of an extra pad per gate, and such an extra pad is normally not allowed in order to maintain the surface area of the integrated circuit device within a predetermined 'budget'; and
- the test, i.e., the gate leakage current measurement, is performed after the power transistor is returned from the state of stress, masking small defects not visible at weak potential which may cause failures in the future life of the product.

It is an object of the present invention to provide a circuit and method for stress testing a transistor in an integrated circuit device wherein the abovementioned disadvantage(s) may be alleviated.

### Statement of Invention

In accordance with a first aspect of the present invention there is provided a circuit for stress testing a transistor in an integrated circuit device as claimed in claim 1.

In accordance with a second aspect of the present invention there is provided a method for stress testing a transistor in an integrated circuit device as claimed in claim 8.

### Brief Description of the Drawing(s)

One circuit and method for stress testing a transistor in an integrated circuit device incorporating the present invention will now be described, by way of example only, with reference to the accompanying drawing(s), in which:
FIG. 1 shows a block schematic circuit diagram of part of an integrated circuit device incorporating circuitry for facilitating stress testing of a power transistor within the integrated circuit device; and
FIG. 2 shows a circuit diagram of a practical circuit for realizing the stress testing circuitry of FIG. 1.

### Description of Preferred Embodiment(s)

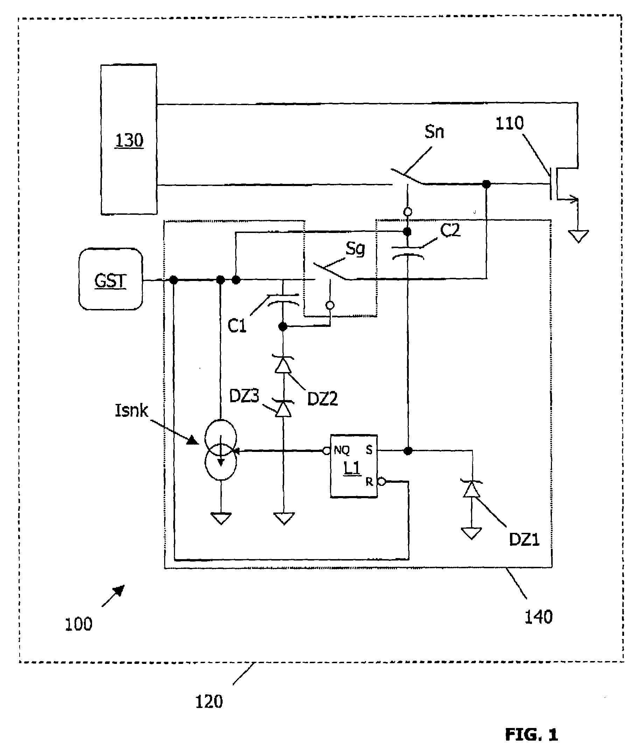

In FIG. 1 there is shown in block schematic form a circuit 100 incorporating the present invention for stress testing a power transistor 110 in an integrated circuit device 120. The circuit 100 has two active switches, Sn and Sg, in order to connect the gate electrode of the power transistor 110 to a normal circuit 130 or to a stress test circuit 140 respectively. The selection is performed by a network composed of a latch L1, the capacitors C1 and C2, by the action (as will be described in greater detail below) of the slew rate of a stress voltage applied to pad GST.

It will be understood that the drain electrode of the power transistor 110 is connected to additional circuitry 130 that is used in normal operation of the integrated circuit, and it will further be understood that the gate electrode of the power transistor 110 is connected, via the switch Sn, to the additional circuitry 130.

In normal operating condition, the switch Sn is closed while the switch Sg is open, L1 is in reset state R, forcing the GST pad to zero voltage, with a given current sink capability Isnk. In this condition, the capacitors C1 and C2 are both discharged, and zener diode DZ1 (with the zener diode stack DZ2 & DZ3) functions to allow charging of the capacitors, starting at different GST threshold voltages.

The two different thresholds are needed to assure that the current Isnk is turned off before the switch Sg becomes closed, in order to avoid undesired extra current. When a voltage ramp is applied to the pad GST (assuming the normally-operating part of the circuit is not operating), if the slew rate of the applied voltage ramp is large enough, the capacitors C1 and C2 both become charged, turning the latch L1 into the set state S. The current Isnk then becomes null or very small, the switch Sn opens, and the switch Sg closes, allowing a direct connection from the pad GST to the power transistor 110.

The voltage is then stabilized to a suitable DC value Vgst. Thus, in this state, ideally no DC current flows, except for the oxide-defect current to be measured.

This state should be held for several hundreds of milliseconds, in order to provide the correct amount of stress to the power transistor 110. In this state, any DC current flow is measured to evaluate any oxide-defect.

From this condition, if the pad GST is driven at zero potential, the latch L1 returns to the R state, allowing the discharge of the residual charge in C1 and C2, by means of the current Isnk.

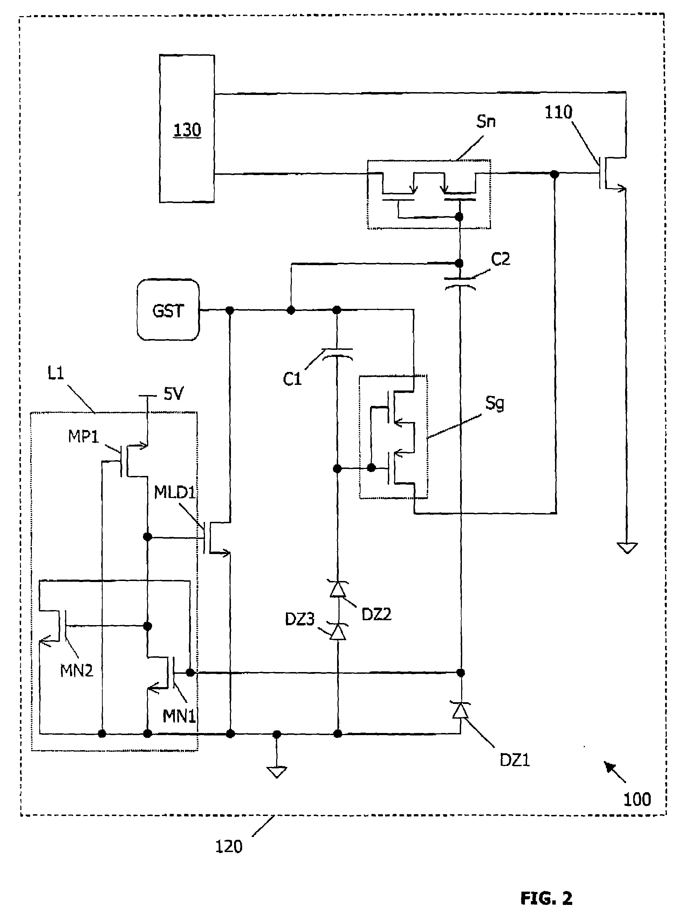

Referring now to Fig. 2, in a practical implementation of the above-described circuit of FIG. 1, the circuit is realized in MOS technology. The switches Sn and Sg are realized by means of two PHV MOS transistors in anti-series connection to assure bilateral switch behavior, since a PHV transistor cannot ensure isolation if the drain potential is higher than the source potential, owing to the intrinsic diode associated with this structure.

The capacitors C1 and C2 are metal-polysilicon capacitors, in order to withstand the applied stress voltage, while the latch L1 and the Isnk current source are realized by MOS transistors MN1, MN2, MP1, MLD1. The zener diodes DZ1, DZ2 and DZ3 allow a charging path for the capacitors C1 and C2, and limit the voltage across the gate-source capacitance of the switches and on the transistor MN1. It will be understood that the zener diode DZ3 may be eliminated if the zener diode DZ2 is stacked with the zener diode DZ1. Non-idealities in this practical circuit are mainly due to the leakage currents flowing through the zener diodes, through the switches in the off state and through the MLD1 transistor.

The value of the capacitors C1, C2 must be sized to fit the stress test duration requirements. Moreover, in practice, the slew rate capability of the stress source, whose current is the measurement to be accomplished, should be taken into account. Practically speaking, currents of tenths of nanoamps are measured even on perfect power transistors, and this is the ultimate limit of the test resolution.

Test procedure using the above circuits is as follows:
1. the correct position and contact of a GST test needle is verified by measuring the current capability of the source Isnk in the normal operating condition, assuring correct behavior when not working (for example, the value of the current Isnk may be expected to be larger than 100 microamps for a voltage on the GST pad less than 100 millivolts).
2. the device is powered off and, by means of a switch, the GST pad is slewed up to 25 V with a slew rate in excess of 10 volts/microsecond; the switch needs to combine fast slew rate with high accuracy of current measurement in automated test equipment (ATE).
3. after some time delay the current is measured (for example, in one series of tests of a variety of different samples, currents in the range of 0 to 60 nanoamps were measured, with the test threshold being set at 1 microamp).
4. finally, the GST pad is set to ground potential and the device is functionally tested to verify the normal operating mode.

It will be appreciated that in testing a semiconductor wafer containing a large number of similar integrated circuit devices, the above procedure may be used, with the same driver circuit (with only one gate stress pad and with a suitable set of switches), to connect different power transistors within the same integrated circuit at the same time, provided that the test limits are set according to the number of connected devices. In the case of a gate failure, the die must be rejected, without the need to know exactly which of the power transistors presented the defect(s). Such failed parts may be later analyzed with known failure analysis methods.

It will also be appreciated that a number of possible improvements may be made to the above test process, such as:
- reducing the GST voltage slew rate in order to improve the size of the capacitors C1 and C2;
- the switches Sn and Sg may be reduced in size, taking into account the performances required in the normal operating mode (these performances are normally related to the size of the parasitic capacitance associated with the power transistor, which, in the majority of cases, should be driven with a suitable high current capability);
- adding gain on the current measured on the power transistor gate (in this case, the magnified current is measured, providing a better S/N ratio, which may be particularly useful in a noisy ATE environment).

It will be understood that the procedure described above for stress testing a transistor in an integrated circuit device provides the following advantages:
- since the integrated circuit's normal-operating circuitry 130 is isolated by the switch Sn during stress testing of the power transistor 110, the test is unaffected by inability of circuitry 130 to withstand the amount of voltage needed for the gate stress, or by the circuitry 130 in this condition sinking a large amount of current, which would otherwise make the necessary current measurement unreliable or impossible.
- the test does not require an extra pad per gate for the purpose of testing, helping to maintain the surface area of the integrated circuit device within a predetermined 'budget'.
- the test, i.e., the gate leakage current measurement, may be performed during the state of stress of the power transistor, allowing detection of small defects (not visible at weak potential) which may cause failures in the future life of the product.

It will also be appreciated that, although in the above description the slew rate of the voltage applied to the pad GST is used as the criterion for determining whether the switch Sn should be closed and the test circuitry should be enabled, other properties (such as, the signal's polarity or pulse width, for example)of the applied signal could alternatively be used if desired.

## Claims

1. A circuit (100) for stress testing a transistor (110) in an integrated circuit device (120), comprising:
a transistor (110) ;
an external connection pad (GST) coupled to the transistor;
a first switch (Sn) coupled between the transistor and circuitry (130) within the integrated circuit device to which the transistor is connected during normal operation of the device;
a second switch (Sg) coupled between the transistor and test circuitry (140) for testing the transistor; and
detecting means (C1, C2, DZ1, DZ2, DZ3) coupled to the pad for detecting when a signal related thereto has a property satisfying a predetermined condition, and for enabling the first switch when the predetermined condition is not satisfied, and for enabling the second switch when the predetermined condition is satisfied; and
testing means (140) for testing the transistor when the predetermined condition is satisfied.

2. The circuit for stress testing according to claim 1, further **characterised in that** the property is slew rate and the predetermined condition is the slew rate being greater than a predetermined value.

3. The circuit for stress testing according to claim 1 or 2, further **characterised in that** the detecting means comprises: a first capacitor (C2) coupled to the first switch to control enablement thereof, a second capacitor (C1) coupled to the second switch to control enablement thereof, and a latch (L1) coupled to the first switch.

4. The circuit for stress testing according to claim 3, further **characterized by** first threshold means (DZ1) coupled to the first capacitor for controlling the level of voltage at which the first capacitor begins to charge, and second threshold means (DZ2, DZ3) coupled to the second capacitor for controlling the level of voltage at which the second capacitor begins to charge, the first and second threshold means having different threshold levels for ensuring that the first and second switches are operated in a predetermined order.

5. The circuit for stress testing according to any preceding claim, further **characterised in that** the transistor (110) is a power transistor.

6. The circuit for stress testing according to claim 5, further **characterised in that** the transistor (110) is an MOS transistor.

7. The circuit for stress testing according to any preceding claim wherein the testing means comprises means for measuring a current associated with the transistor.

8. A method for stress testing a transistor (110) in an integrated circuit device (120), comprising:
providing an external connection pad (GST) coupled to the transistor;
providing a first switch (Sn) coupled between the transistor and circuitry (130) within the integrated circuit device to which the transistor is connected during normal operation of the device;
providing a second switch (Sg) coupled between the transistor and test circuitry (140) for testing the transistor; and
applying a signal to the external connection pad, detecting when the signal has a property satisfying a predetermined condition, and enabling the first switch when the predetermined condition is not satisfied, and enabling the second switch when the predetermined condition is satisfied; and
testing the transistor when the predetermined condition is satisfied.

9. The method for stress testing according to claim 8, further **characterised in that** the property is slew rate and the predetermined condition is the slew rate being greater than a predetermined value.

10. The method for stress testing according to claim 8 or 9, further **characterised by** providing: a first capacitor (C2) coupled to the first switch, a second capacitor (C1) coupled to the second switch, and a latch (L1) coupled to the first switch.

11. The method for stress testing according to claim 10, further **characterized by** providing first threshold means (DZ1) coupled to the first capacitor for controlling the level of voltage at which the first capacitor begins to charge, and second threshold means (DZ2, DZ3) coupled to the second capacitor for controlling the level of voltage at which the second capacitor begins to charge, the first and second threshold means having different threshold levels for ensuring that the first and second switches are operated in a predetermined order.

12. The method for stress testing according to claim 8, 9, 10 or 11, further **characterised in that** the transistor is a power transistor.

13. The method for stress testing according to claim 12, further **characterised in that** the transistor is an MOS transistor.

14. The method for stress testing according to any one of claims 7-13 wherein the step of testing comprises measuring a current associated with the transistor.
